(19) **Europäisches Patentamt / European Patent Office / Office européen des brevets**

(11) **EP 1 416 628 B1**

(12) **EUROPEAN PATENT SPECIFICATION**

(45) Date of publication and mention
of the grant of the patent:
**25.12.2013  Bulletin 2013/52**

(51) Int Cl.:
*H03F 3/24* (2006.01)     *H03F 1/32* (2006.01)
*H03F 3/60* (2006.01)

(21) Application number: **02024263.2**

(22) Date of filing: **31.10.2002**

(54) **Amplification systems and methods using feedback loop**

Verstärkersysteme und Verfahren mit einer Rückkopplungsschleife

Systèmes et techniques d'amplification utilisant une boucle de rétroaction

(84) Designated Contracting States:
**AT BE BG CH CY CZ DE DK EE ES FI FR GB GR
IE IT LI LU MC NL PT SE SK TR**

(43) Date of publication of application:
**06.05.2004  Bulletin 2004/19**

(73) Proprietor: **Hewlett-Packard Development
Company, L.P.
Houston, TX 77707 (US)**

(72) Inventors:
• **Christensen, Steen Borg
9490 Pandrup (DK)**
• **Gentsch, Morten Brok
9000 Aalborg (DK)**

(74) Representative: **WP Thompson
55 Drury Lane
London
WC2B 5SQ (GB)**

(56) References cited:
EP-A- 0 054 811     EP-A- 0 638 994
WO-A2-02/060051     WO-A2-02/087072
US-A- 5 570 063     US-A- 5 920 808
US-B1- 6 265 943

• RAAB F H ET AL: "POWER AMPLIFIERS AND
TRANSMITTERS FOR RF AND MICROWAVE"
IEEE TRANSACTIONS ON MICROWAVE THEORY
AND TECHNIQUES, IEEE INC. NEW YORK, US,
[Online] vol. 50, no. 3, March 2002 (2002-03),
pages 814-826, XP002237573 Retrieved from the
Internet: <URL:http://ieeexplore.ieee.org>
[retrieved on 2003-04-08]

## Description

### Field of the invention

The invention relates to radio transmitters for transmitting radio signals which vary in amplitude as well as in phase or frequency. The invention relates in general to amplification of signals, and in particular, to amplification of signals utilising a feedback loop.

### Background of the invention

One target in designing amplifier systems for signals containing amplitude modulation AM is to make their operating characteristics as linear as possible. This means that the amplifier response with which the signal is amplified is as constant as possible, and further, that the gain can be as carefully as possible set to a new target value when necessary.

When a higher transmitter efficiency is wanted, the power amplifier can be linearised with a correctional loop. In order to obtain good linearity, several methods are known. Most of them use feedback or feedforward techniques. The idea of using a feedback signal in an amplifier is that a part of the amplified signal - i.e. the feedback signal - is fed to a previous amplifying stage, where based on the feedback signal the amplification of an input signal is correspondingly altered. The idea of using a feedforward signal in an amplifier is that a part of signal - i.e. the feedforward signal - is fed to the output signal, for example, by using a coupler in order to modify the shape of the output signal.

The correctional loop methods suffer from reverse intermodulation if no circulator or isolator is used. The amount of reverse intermodulation depends on the ratio of the transmitted power and the power or the unwanted inteferer. This means that for a constant level of interference the amount of reverse intermodulation depends on the output power of the transmitter. Signals from outside, e.g. from the antenna, are transferred backwards through the correctional loop thus creating reverse intermodulation. At the same time the correctional loop can be designed to introduce output power independent of temperature, frequency and supply voltage variations.

In the US patent 5,570,063 an amplifier according to the category of the subject-matter of the independent claims is disclosed. The amplifier uses feedback loops which perform a predistortion of the signal to be amplified.

European patent application 0 054 811 A1 and US patent 5,920,808 propose solutions for equalising signals in an amplifier with a single feedback loop. International patent applications WO 02/060051 A2 and WO 02/087072 A2 disclose methods how to correct nonlinearities caused by transistors within a feed forward loop.

Systems using feedback are very sensible to adjacent channel and co-channel interference. This can easily cause nonlinearities or instabilities for the amplifier, thus degrading the characteristics of the amplifier. In prior art there are many suggestions how to overcome these problems. US patent 6,320,461 B1 discloses one possibility for implementing a feedforward RF power amplifier. The amplifier uses slope compensation in combination with two modulated pilot signals to control intermodulation distortion cancellation.

Published UK patent application GB 2 354 384 proposes an amplifying method wherein both high- and low-sensitivity detectors are used in detecting the amplified transmission signal. A part of the amplified transmission signal is extracted by a coupler and supplied to a detection circuit section. A high-sensitivity detector is used for detecting low-level signals; low-sensitivity detector is used for detecting signals with higher power levels.

US 6, 625, 943B1 relates to a system for controlling a bias circuit by sensing RF amplifier output power and compensating for a dominating quiescent bias current which includes an amplifier transistor and two sampling transistors.

A feedback amplifier has also been disclosed in European patent application 0 503 718 A1. A portion of the amplified signal is coupled out using a quarter wave coupler and then supplied to a detector system. An output of the system is supplied by way of a resistor to the inverting input of a comparator whose output is connected to a control input of the power amplifier. An artificial detector is used whenever the power output is below a level which is detectable by the detector system ie when there otherwise were no feedback to the comparator.

Feedback methods for a polar loop amplifier have recently been proposed in UK patent application GB 2 370 169 A, US patent application 2002/0093378 A1, and European patent applications EP 1 217 753 A1 and EP 1 217 754 A1. These patent applications rely on the technological background disclosed in articles from Leonard R. Kahn: "Single-Sideband Transmission by envelope elimination and restoration", Proceedings of the I.R.E, 1952, p. 803-806, and on an article by V. Petrovic and W. Gosling "Polar-Loop Transmitter", Electronics Letters, 10th May 1979 Vol 15 No 10, pp. 286-288. Further, the designated inventor of these last four patent applications referenced, P. A. Nielsen, has in his Ph. D. thesis written a nice introductory part for the problematics.

One problem related with the solution disclosed in the four latter patent applications is that a digital signal processor is requested to perform some operations thus increasing the complexity of the solution.

It still remains a problem how to increase the linearity of a feedback amplifier without using a complex and costly solution, such as a circulator or an isolator. The latter solutions, circulator or isolator, are even not possible when the device wherein the amplifier is to be used should be very small.

**Summary of the invention**

This and other objectives of the invention can be achieved with a method and a system according to any one of the independent patent claims.

According to an embodiment of the present invention there is provided a power control method for an amplifier comprising the steps of:

- amplifying an input signal (SIN) to an output signal (SOUT) by using a plurality of amplifying stages;
- collecting a first reference signal (SREF1) representing the output signal (SOUT);
- collecting a second reference signal (SREF2);
- producing a feedback signal (SFBK) using the first reference signal (SREF1) and the second reference signal (SREF2) by combining the first reference signal and the second reference signal;
- using said feedback signal (SFBK) for controlling the amplifying step to amplify a corrected input signal (SIN') to the output signal (SOUT), thus enhancing the linearity of the amplifier (105) wherein the corrected input signal (SIN') is produced by correcting the input signal (SIN) with a signal ($SFBK_{am}$, $SFBK_{pm}$) derived from the feedback signal (SFBK);
- wherein the second reference signal (SREF2) is collected from the amplifying step by using a transistor (T2, Y fingers) that is a down-scaled (Y<<X) version of a transistor (T1, X fingers) of the last amplifying stage, representing the output signal (SOUT);
- whereby the transistor (T1) in the last amplifying stage and the down-scaled transistor (T2) are coupled to be provided with a signal (SIN2) to be amplified which is the same for both of the transistors (T2, T2).

According to one aspect of the present invention, the controlling of the amplifying step includes the steps of i) in a first comparison step, comparing an amplitude representation of the input signal with an amplitude representation of the correction signal, ii) in a second comparison step, comparing a phase representation of the input signal with a phase representation of the correction signal, and iii) using a signal derived from the first comparison step for controlling a power amplification step of a signal derived from the second comparison step, thus producing the output signal. In this way polar loop amplification can more effectively be linearised, which facilitates the design and construction of a highly linear PM and/or AM transmitter, for example.

According to one aspect of the present invention, the controlling of the amplifying step further includes the step of attenuating or amplifying the signal derived from the first amplification step before it is used for controlling the power amplification step. This helps to increase the dynamic range of the loop amplifier system.

According to one aspect of the present invention, the correction signal is produced by combining the first reference signal with the second reference signal by giving them weights and/or phases used in the combining step. Using such a construction in combining the signals, the linearity can be further enhanced to compensate for possible variations in the observed interference level. According to one aspect of the present invention, the weights and/or phases are given depend on the power level of the output signal. Such a solution helps in assigning the system wherein the method is used a system-specific power level dependent interference characteristics.

According to one aspect of the present invention, the first reference signal is collected by coupling it from the output signal after the amplifying step; and/or the second reference signal is collected from the amplifying step by taking the second reference signal from a transistor used in the amplifying. In such a way, the quality of the feedback signal can be enhanced as compared to state-of-art systems for obtaining the feedback signal.

According to technology related to embodiments of the present invention, there is provided, a power sense circuit for an amplifier, especially to be used in connection with the power control method as presented in any one of the preceding claims, includes i) amplifying means for making a current representing the output signal in a last power amplifying stage by using a down-scaled version of the last transistor in the power amplifying stage, to an amplified signal, ii) a quarter wave transformer for keeping the drain load of the power sense circuit approximately constant, and iii) a tuned circuit for producing the second reference signal responsive to the current to be used as a feedback signal in an amplifier. Such a power sense circuit is a novel way to obtain a feedback signal, and even with the advantage that the feedback signal obtained suffers less from interfrequency and channel interference than a feedback signal obtained, say, with a coupler.

According to technology related to embodiments of the present invention, there is provided, a amplifier includes i) means for combining a first reference signal representing the output signal with a second reference signal representing the output signal in the last power amplifying stage by using a down-scaled version of the last transistor in the power amplifying stage, the combining means adapted to produce a feedback signal, and ii) means for feeding the feedback signal to a power amplifier. One of the advantages of such a signal combiner is that different feedback signals can be combined thus enhancing the quality of the feedback signal.

A feedback system for giving a feedback signal for a power amplifier as defined in claims 12 to 15 has the advantage that the feedback signal obtained suffers less from interfrequency and channel interference than a feedback signal obtained with conventional methods, and, as a consequence, enhances the linearity of the power amplifier. .A mobile terminal, especially a mobile phone, or a base station, includes a feedback system according to any one of claims 12 to 15. Such devices can thus be made to show highly linear power RF transmitter characteristics.

**Brief description of the drawings**

In the following, the invention and its preferred embodiments are described more closely referring to the examples shown in Figures 1 to 4 in the appended drawings, wherein:

Figure 1      illustrates a basic feedback amplifier showing the principle of the present invention,

Figure 2A      presents a typical amplitude modulated (AM) signal which needs to be corrected for distortion,

Figure 2B      presents a typical phase modulated (PM) signal which needs to be corrected for distortion,

Figure 3      an amplifier in which the inventive feedback signal can be used, and

Figure 4      illustrates one possibility for obtaining the second reference signal SREF2 from the power amplifier 105. Only the last stage of the power amplifier is shown in figure 4 together with a possible build in sense functionality.

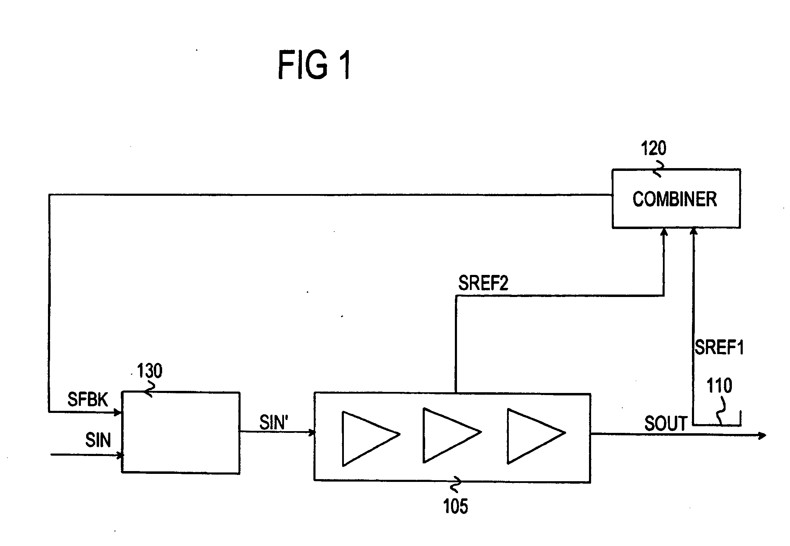

Like reference signs refer to corresponding parts and elements throughout Figures 1-4.

**Detailed description of the invention**

Figure 1 shows an example revealing some principles of the present invention. An input signal SIN is fed to a correction unit 130. The correction unit 30 modifies the input signal SIN with a feedback signal SFBK, thus producing a corrected input signal SIN'. This corrected input signal SIN' is then fed into a power amplifier 105 which amplifies the corrected input signal SIN' to an output signal SOUT.

The feedback signal SFBK is generated in a combiner 120 by combining a first reference signal SREF1 with a second reference signal SREF2. The first reference signal SREF1 is obtained from the output signal SOUT using a coupler 110. The second reference signal SREF2 is obtained in the power amplifier 105 by using a down-scaled version of the last transistor in the last power amplifying stage. Therefore, the first reference signal SREF1 represents the output signal SOUT, whereas the second reference signal SREF2 represents the output signal SOUT of the last transistor in the last power amplifying stage.

In the combiner 120 the feedback signal SFBK is formed by combining the first reference signal SREF1 with the second reference signal SREF2 using a relation:

$$SFBK = C_1\ SREF1 + C_2\ SREF2,$$

where $C_1$ and $C_2$ are appropriate complex numbers. In this way, both amplitude and phase of the first and second reference signal can be altered. In the following a simple explanation of the combiner coefficients $C_1$ and $C_2$. For low power levels $C_1 \approx 0$; $C_2 \approx 1$ the optimal feedback signal SFBK is the second reference signal SREF2, and for high power levels $C_1 \approx 1$; $C_0 \approx 0$ the optimal feedback signal SFBK is the first reference signal SREF1. For medium power levels the optimal feedback signal SFBK is preferably a combination of the two reference signals SREF1 and SREF2 so that the feedback signal SFBK optimally characterises the properties of the output signal SOUT.

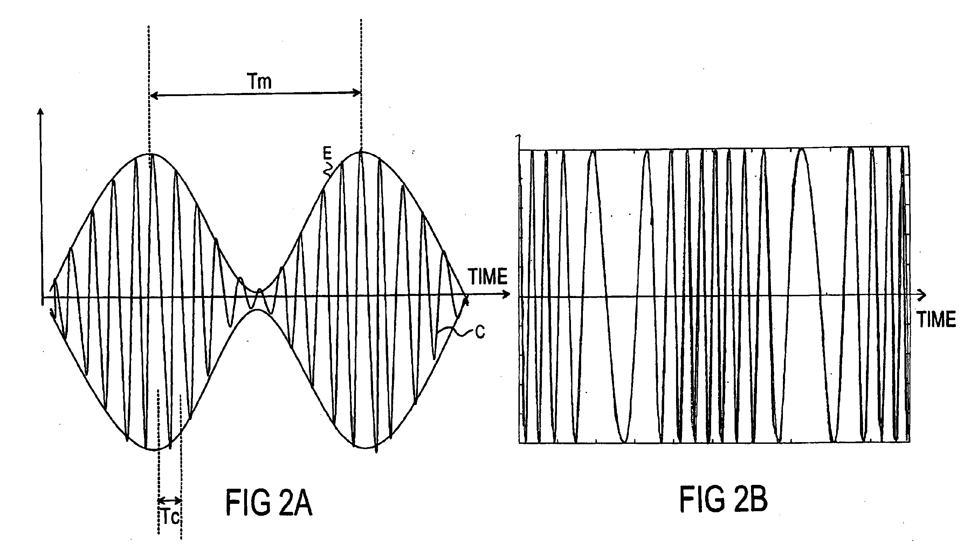

Figure 2A presents a typical amplitude modulated (AM), and Figure 2B a typical phase modulated (PM). In practice, both kinds of signals need to be corrected for distortion. The outer curve E of Figure 2A describes the envelope of the output signal SOUT, whereas the inner curve S describes the variation of the actual signal within the envelope. The envelope of the modulating signal varies with an angle frequency $f_m = 1/T_m$ and the carrier signal varies with an angle frequency $f_c = 1/T_c$.

The AM signal which is depicted in Figure 2 is obtained using the relation

$$Y_{AM}(t) = [1 + A \sin (2\pi\ f_m t)]\ \cos(2\pi\ f_c t),$$

where A describes the modulation depth.

The PM signal which also is depicted graphically in Figure 2 is obtained using the relation

$$Y_{PM}(t) = \cos\ [k_p \sin(2\pi\ f_m t) + 2\pi\ f_c t],$$

where $kp$ describes the phase modulator constant.

For example, for an 8-PSK EDGE signal, a combination of the two modulation schemes is used.

Such modulation techniques are needed e.g. in 8-PSK modulation used for Enhanced Data Rates for GSM Evolution EDGE applications between mobile terminals and base stations. Mobile terminals and base stations therefore include power amplifier system which should be easily controllable and as linear as possible. EDGE amplification, for example, should be performed according to principles defined in 3GPP TS 45.005 V5.2.0 3rd Generation Partnership Project; Technical Specification Group GSM/EDGE Radio Access Network; Radio transmission and reception (Release 5). Typical values for $f_c$ are between 880 and 915 MHz, and for $f_m$ base band signals up to approximately 240 kHz, but, for example, in the mentioned specification also other carrier frequencies exist. A obtains values of approximately from 0.06 to 0.45. Likewise, values for the $k_p$ can be found from the specifications.

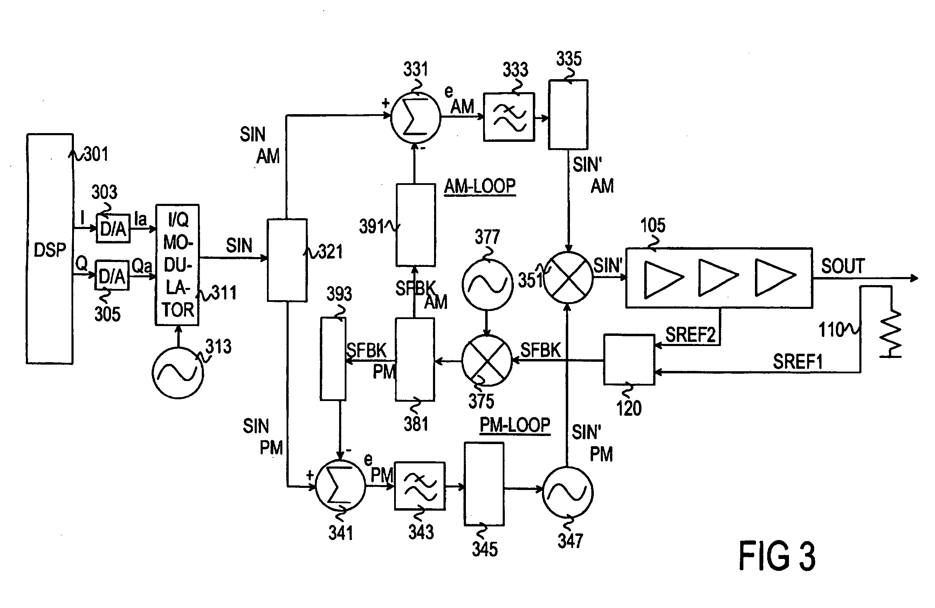

Figure 3 describes an example of an amplifier in which the inventive feedback signal can be used. Figure 3 and the following description contain many references for different signals; in the following mostly references only are used. The terminology is to be understood in the spirit of the terminology presented in the annexed List of used references.

The Digital Signal Processor DSP 301 obtains signal from other circuits of a mobile phone or a base station. It outputs digital I and Q base band signals, of which the digital I signal is converted to an analog base band signal Ia in Digital-to-Analog Converter DAC 303, and the digital Q signal is converted to an analog base band signal Qa in a Digital-to-Analog Converter DAC 305.

The analog base band signal Ia is then combined with the analog base band signal Qa in I/Q modulator 311 by mixing them with an intermediate-frequency signal obtained from the oscillator 313. The I/Q modulator 311 produces the input signal SIN.

The input signal SIN is split in signal splitter 321 which is an amplitude-phase splitter. The signal splitter 321 divides the input signal SIN to two signals $SIN_{AM}$ and $SIN_{PH}$. The signal $SIN_{AM}$ is the envelope of the input signal SIN which is a base-band signal, and $SIN_{PH}$ is the voltage limitation of the input signal SIN, i.e. it contains phase information only. $SIN_{PH}$ is therefore a square wave signal where the zero crossing represents the phase of the original signal and the average period is the reciprocal of the intermediate frequency.

The signal $SIN_{AM}$ is fed to an amplitude loop AM LOOP. This means that it is fed to a positive input of the comparator 331. The comparator 331 subtracts from the signal $SIN_{AM}$ the input signal of the negative input which in this case is the amplitude part $SFBK_{AM}$ of the feedback signal SFBK. The difference signal $e_{AM}$ is low-pass filtered in a low-pass filter 333, and then fed through a constant gain amplifier 335. In practice, the function of the constant gain amplifier 335 is just to align the gain in the AM loop; in some cases it can be omitted. The resulting amplitude part $SIN'_{AM}$ of the corrected input signal SIN' from the amplitude loop AM is then fed to a mixer 351.

Similarly, the signal $SIN_{PH}$ is fed to a phase loop PH LOOP. The phase detector 341 multiplies the signal $SIN_{PH}$ and an ampflified phase put at the feedback signal $SFBK_{PM}$ so that the output $e_{PM}$ represents the phase difference of the two incoming signals $SIN_{PH}$ and $SFBK_{PM}$ according to the signs in Figure 3. In this case, the signal coming to the negative input of the phase detector 341 is the phase part $SFBK_{PM}$ of the of the feedback signal SFBK. The resulting difference signal $e_{PM}$ is then low-pass filtered in a low pass filter 343 to remove unwanted signals. The low-pass filtered signal is then amplified in the constant gain amplifier 345 before it is fed to a voltage controlled transmitter oscillator 347. The effect of this signal is that it changes the output of the voltage controlled transmitter oscillator 347, the output signal $SIN'_{PM}$ which is at the carrier frequency, say 900 MHz, and is the tactually phase part $SIN_{PM}$ of the corrected input signal SIN'.

The mixer 351 mixes the phase part $SIN'_{PM}$ and amplitude part $SIN'_{AM}$ in order to produce the corrected input signal SIN'. In practice, this means that the phase part $SIN'_{PM}$ of the corrected input signal SIN' has a constant amplitude, such as 1 V, whereas its phase changes. The amplitude part $SIN'_{AM}$ of the corrected input signal SIN', on its behalf, has only variation in its magnitude. The magnitude of the amplitude part $SIN'_{AM}$ of the corrected input signal is multiplied by the phase part $SIN'_{PM}$ of the corrected input signal SIN', thereby producing the complete corrected input signal SIN' which is fed to the power amplifier 105.

The power amplifier amplifies the corrected input signal SIN' to an output signal SOUT. The target power level depends on the network and the phones power class (see the specifications).

A first reference signal SREF1 representing the output signal is obtained for feedback purposes by a coupler 110. This signal SREF1 may optionally come directly from the output signal SOUT, from a capacitor, from an attenuator, or from any other combination of these not shown in Figure 3. A second reference signal SREF2 representing the output signal SOUT of the last transistor in the last power amplifying stage.

According to the present invention, by combining the first reference signal SREF1 with the second reference signal SREF2 in a suitable manner it is possible to obtain a suitable feedback signal SFBK which obtain an feedback system with high immunity against adjacent channel and co-channel interference; therefore, such a feedback signal SFBK is better suitable for feedback purposes. As an advantage, the linearity of the amplifier will therefore be enhanced.

The first reference signal SREF1 and the second reference signal SREF2 are combined in the combiner 120 as already described. The feedback signal SFBK is fed to a a down converter 375 which obtains the signal needed for downconverting from an oscillator 377. In practice, this oscillator 377 may be of the same type as the voltage controlled transmitter oscillator 347.

The to intermediate-frequency down-converted feedback signal is then fed to a signal splitter 381 that has similar characteristics as the signal splitter 321. This signal splitter can be built as a power splitter followed by an envelope detector in the AM loop branch and a limiter in the PM loop branch. The same can be applied for the signal splitter 321, though this is not shown. A magnitude representation of the intermediate-frequency feedback signal is fed to a constant gain amplifier 391 which outputs the amplified amplitude part $SFBK_{AM}$ of the feedback signal SFBK. A phase representation of the intermediate-frequency feedback signal is fed to a constant gain amplifier 393 which outputs the amplified phase part $SFBK_{PM}$ of the feedback signal SFBK.

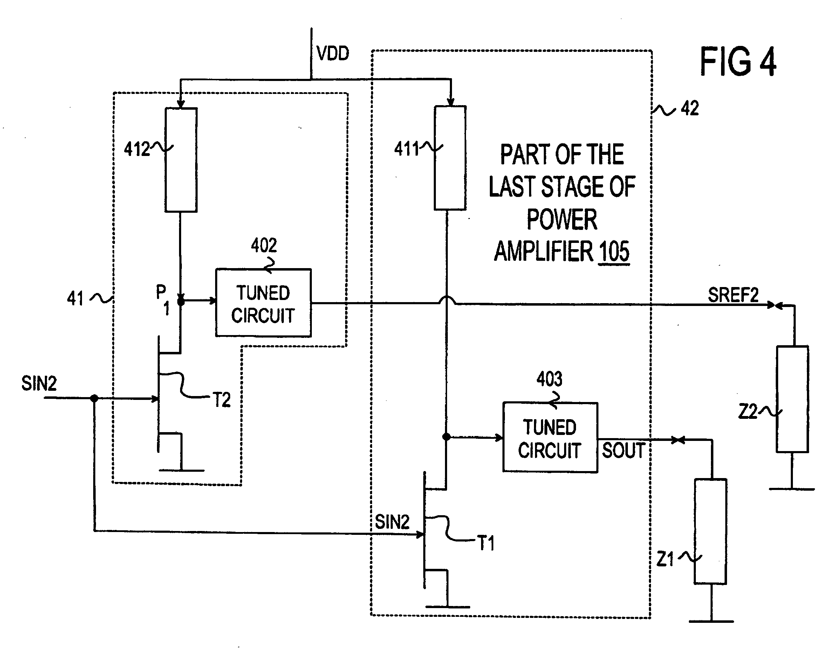

Figure 4 is a diagram showing an example of the sensing circuitry 41 added to the part of the last stage 42 of power amplifier 105. In the example, the sensing circuitry 41 detects a voltage of signal SIN2 which can be converted to the current in the dummy load Z2. The signal SIN2 represents the output signal SOUT at a point where the amplification step has not been completed, but the corrected input signal SIN' has already been amplified at least over one amplifier stage. The quarter wave ($\lambda/4$) transformers 411 and 412 can be interchanged with coils (or a lumped element network), the purpose of the quarter wave transformer (412) being to separate the drain load and the drain of the transistor from the power supply.

Figure 4 illustrates thus one possibility for obtaining the second reference signal SREF2 from the power amplifier 105. The fed signal SIN2 is first amplified to a current signal SIN2 using a transistor T2 which may be a Field Effect Transistor FET, for example. Then a tuned circuit 402 is used for producing the second reference signal SREF2 responsive to the signal SIN2 to be used as a feedback signal in an amplifier.

A part of the current obtained from a voltage source VDD is led from point P1 to a tuned circuit 402 after the quarter wave transformer 412. Other kind of implementation, such as involving the usage of a coil, is also possible. A tuned circuit 402 produces the second reference signal SREF2 responsive to the current through the FET.

According to one aspect of the present invention, a power sense circuitry 41 and its functionality build into the amplifier block are used as a second source of feedback signal SFBK. Currently, the most commonly used current sensors 110 on the last stage of a high power amplifier do not give usable feedback that were immune to reverse IM. Further, they are costly on the efficiency, since the method introduces losses to the output power or to the supply line, depending on the implementation.

According to the present invention, in order to obtain a second feedback signal SFBK2 a down scaled copy or version of the final amplifier stage is made, and then the power sensing is performed on the smaller transistor T2.

According to one further aspect of the present invention, the down-scaled version of the final power amplifier stage is placed in parallel with the actual final power amplifier stage. Also the dummy load Z2 is a down-scaled version of the actual last stage of the power amplifier load Z1. In this way, there is no longer direct signal path from the antenna to the sense output of the power amplifier 105, nor backwards into the correctional loops AM-LOOP, PM-LOOP. This makes the sensing method as described immune to unwanted interfering signals.

Other advantages of the solutions presented are that the losses can be down-scaled with approximately the same factor as that between two transistors. So, if the large output stage transistor T1 consists of X fingers (if a regular transistor is used - otherwise a different form of down scaling can be used), the downscaled or smaller transistor T2 could include Y fingers (Y<<X). Likewise, for the loads that these transistors T1 and T2 see ($Z_L$ for the large transistor T1 and $Z_{Lo}*X/Y$ for the smaller transistor T2).

The power amplifier 105 includes a plurality of transistors thus forming more stages. The first amplifier stage amplifies the signal a bit and the second one a bit more and so on, whereas the last amplifier stage amplifies the signal up to the wanted output power. Basically, the corrected input signal SIN' is amplified using the transistors such as T1 in Figure 4.

Currently, most GSM power amplifiers are made of three stage amplifiers where the T1 is the last stage of the power amplifier. T2 is then be added on to the same input as the input to the last amplifier stage (ie T1).

One solution is to use the functionality of a power sense circuit 41 build into the power amplifier 105 in order to obtain the second reference signal SREF2. The currently most commonly used current sense on the last stage of a high power amplifier does not give a usable feedback that is immune to reverse intermodulation. In addition, it introduces losses on the output power since it introduces voltage drop in the the supply line, the size of the voltage drop depending on the implementation.

Therefore, according to the present invention, a down-scaled copy of the final amplifier stage transistor T1 is made. This copy can then be used for power sensing on the smaller transistor T2. Hence there will be no longer any direct signal path from the antenna to the sense out signal SREF2 of the power amplifier block. This makes the second reference signal SREF2 extremely immune to unwanted interfering signals. It also scales down signal loss with approximately same scale as used between the two transistors (T1 and T2).

For example, if the large output stage transistor T1 consists of X fingers, the down-scaled ie smaller transistor T2 has only Y fingers where Y<<X.

Transistor T1 sees the load Z1 through the tuned circuit 403, which transforms the load impedance Z1. Transistor T2 sees the load Z2 through the tuned circuit 402 transforming the load impedance Z2. For the loads the relation Z2=Z1*X/Y is valid when the impedance transformation is performed the tuned circuits 402 and 403. If, on the other hand, the tuned circuit 402 is chosen differently, difference impedance transformation than the one of 403 could be chosen, then it would be possible to get the dummy load Z2 down in the same order of impedance as Z1, not shown here.

On one hand, the first reference signal SREF1 can be polluted by unwanted incoming signal from the antenna and could in the worst case be comparable in power to the low output power level. Therefore the reverse intermodulation is usually the greatest problem at lower power levels. When the power level grows, this problem disappears. On the other hand, at higher output power levels, the allowed power window is normally narrower which makes it a problem to stay within the specified power level window. Spectrum broadening (or spectral regrowth) is also a problem under these conditions. This can be the problem e.g. when the impedance of the antenna changes. The change can only be detected in the first reference signal SREF1 from the output coupler 110, because the second reference signal SREF2 does not include the actual power amplifier block load presented to the last amplifier stage or stages. These considerations give the theoretical framework on which the combination of the first and second reference signals SREF1 and SREF2 is based.

Using the solution according to the previous examples for constructing the feedback signal SFBK, the reverse intermodulation can effectively be avoided. Especially this is the case when the first reference signal SREF1 is used for higher power levels and the second reference signal SREF2 is used for lower power levels. At output power less than 10 or 15 dBm the reverse intermodulation signal received by the antenna is most significant; therefore SREF2 should be chosen for these power levels.

For medium power levels the optimum feedback is preferably an equal combination of the two feedback signals SREF1 and SREF2. As mentioned above, even advanced complex combinations can be used. In this way, the effect which the standing wave ratio SWR causes at the power amplifier can still be kept in the feedback loop at higher output power levels. Typically, the SWR changes when the environment of the antenna changes, such as when the user of the device, wherein the method or device corresponding the present invention is used, changes his environment. Using this invention optimises the linearisation of the amplifier, because the SWR information is mainly important at higher output power levels.

The calibration of the output power at the antenna input can be done with existing and normal power adjustments in the production and then stored in memory of the phone. The normally rather large power variations due to temperature and supply voltage swings can be corrected by the loop to be small enough to fit in the allowed power variation window.

Although the invention was described above with reference to the examples shown in the appended drawings, it is obvious that the invention is not limited to these but may be modified by those skilled in the art without difference from the scope of the invention. For example, the  phase and amplitude modulation PM/AM signals in the feedback signal SFBK. The invention can be used in any transmitter where the output signal varies in amplitude and in phase or frequency. Also such amplifier configurations which include envelope feedback and/or Cartesian loops, or any other kind of amplification loops, can be used.

**List of used references**

| | |
|---|---|
| 41 | sensing circuitry |
| 42 | part of the last stage of power amplifier 105 |
| 105 | power amplifier |
| 110 | coupler |
| 120 | combiner |
| 130 | correction unit |

| | |
|---|---|
| 301 | Digital Signal Processor DSP |
| 303 | Digital-to-Analog Converter DAC |
| 305 | Digital-to-Analog Converter DAC |
| 311 | I/Q modulator |
| 313 | oscillator |
| 321 | signal splitter |
| 331 | comparator |
| 333 | low-pass filter |
| 335 | constant gain amplifier |
| 341 | phase detector |
| 343 | low-pass filter |
| 345 | constant gain amplifier |
| 347 | voltage controlled transmitter oscillator |
| 351 | mixer |
| 375 | down converter |
| 377 | oscillator |
| 381 | signal splitter |
| 391 | constant gain amplifier |
| 393 | constant gain amplifier |
| 402 | tuned circuit |
| 403 | tuned circuit |
| 411 | quarter wave transformer |
| 412 | quarter wave transformer |
| T1, T2 | transistors |
| Z1 | power amplifier system load |
| Z2 | dummy load |

| | |
|---|---|
| SIN | input signal |
| SOUT | output signal |
| SREF1 | first reference signal |
| SREF2 | second reference signal |
| SFBK | feedback signal |
| $SFBK_{AM}$ | amplitude part of the feedback signal SFBK |
| $SFBK_{PM}$ | phase part of the feedback signal SFBK |
| SIN' | corrected input signal |
| I | digital base band signal |
| Ia | analog base band signal |
| Q | digital base band signal |
| Qa | analog base band signal |
| $SIN_{AM}$ | envelope of the input signal SIN |
| $SIN_{PH}$ | voltage limitation of the input signal SIN |
| $SIN'_{AM}$ | amplitude part of the corrected input signal SIN' |
| $SIN'_{FM}$ | phase part of the corrected input signal SIN' |
| $e_{AM}$ | difference signal in the amplitude loop |
| $e_{PM}$ | difference signal in the phase loop |
| SIN2 | output signal SOUT at a point where the amplification step has not been completed |

**Claims**

1. A power control method for an amplifier comprising the steps of:

 - amplifying an input signal (SIN) to an output signal (SOUT) by using a plurality of amplifying stages;
 - collecting a first reference signal (SREF1) representing the output signal (SOUT);
 - collecting a second reference signal (SREF2);
 - producing a feedback signal (SFBK) using the first reference signal (SREF1) and the second reference signal (SREF2) by combining the first reference signal and the second reference signal;
 - using said feedback signal (SFBK) for controlling the amplifying step to amplify a corrected input signal (SIN') to the output signal (SOUT), thus enhancing the linearity of the amplifier (105) wherein the corrected input signal (SIN') is produced by correcting the input signal (SIN) with a signal (SFBK$_{am}$, SFBK$_{pm}$) derived from the feedback signal (SFBK);
- wherein the second reference signal (SREF2) is collected from the amplifying step by using a transistor (T2, Y fingers) that is a down-scaled (Y<<X) version of a transistor (T1, X fingers) of the last amplifying stage, representing the output signal (SOUT);
- whereby the transistor (T1) in the last amplifying stage and the down-scaled transistor (T2) are coupled to be provided with a signal (SIN2) to be amplified which is the same for both of the transistors (T2, T2).

2. A method according to claim 1 wherein: the controlling the amplifying step includes the steps of:

- in a first comparison step, comparing an amplitude representation of the input signal (SIN) with an amplitude representation of the feedback signal (SFBK);
- in a second comparison step, comparing a phase representation of the input signal (SIN) with a phase representation of the correction signal (SFBK); and
- using a signal derived from the first comparison step for controlling a power amplification step of a signal derived from the second comparison step to produce the output signal (SOUT).

3. A method according to claim 1 or 2 wherein: the controlling of the amplifying step further includes the step of: amplifying/attenuating the feedback signal (SFBK) before any the first and/or the second comparison step.

4. A method according to claim 3 wherein: the controlling of the amplifying step further includes the step of:

- the signal derived from the first amplification step is first attenuated/amplified before it is used for controlling the power amplification step.

5. A method according to any one of the preceding claims, wherein: the feedback signal (SFBK) is produced by combining the first reference signal (SREF1) with the second reference signal (SREF2) by giving them weights (mod($C_1$, $C_2$)) and/or phases (arg($C_1$, $C_2$)) used in the combining step.

6. A method according to claim 5, wherein: the weights (mod($C_1$, $C_2$)) and/or phases (arg($C_1$, $C_2$)) are given depend on the power level of the output signal (SOUT).

7. A method according to any one of the preceding claims, wherein: the first reference signal (SREF1) is collected by coupling it from the output signal (SOUT) after the amplifying step.

8. A method according to any one of the preceding claims, wherein: the first reference signal (SREF1) is collected by an attenuator or a capacitor from the output signal (SOUT) after the amplifying step.

9. A method according to any one of the preceding claims, **characterised in that**:

it utilises a feedback loop which is a polar loop.

10. A method according to any one of the preceding claims, **characterised in that**:

it utilises a feedback loop which is an envelope feedback loop.

11. A method according to any one of the preceding claims, **characterised in that**:

it utilises a feedback loop which is a Cartesian loop.

12. A feedback system for giving a feedback signal for a power amplifier (105), the system comprising a plurality of amplifier stages for amplifying an input signal (SIN) to an output signal (SOUT):

- means (110) for obtaining a first reference signal (SREF1) representing the output signal;
- a power sense circuit (41) for obtaining a second reference signal (SREF2);
- a signal combiner (120) for producing a feedback signal (SFBK) by combining the first reference signal (SREF1) with the second reference signal (SREF2);

- a comparator (331) and/or a phase detector (341) adapted to correct the input signal (SIN) with a signal (SFBK$_{AM}$, SFBK$_{PM}$) derived from the feedback signal (SFBK) in order to produce a corrected input signal (SIN') for amplifying the corrected input signal (SIN') to the output signal (SOUT) with the amplifier (105), thus enhancing the linearity of the amplifier(105);
- whereby the power sense circuit (41) comprises
a transistor (T2, Y fingers) that is a down-scaled (Y<<X) version of the transistor (T1, X fingers) of the amplifier (105) for obtaining the second reference signal (SREF2) representing the output signal of a last amplifying stage; and
- whereby the transistor (T1) of the last amplifying stage and the down-scaled transistor (T2) are coupled to be provided with a signal (SIN2) to be amplified which is the same for both of the transistors (T2, T2).

13. A feedback system according to claim 12 **characterised in that**:

the power sense circuit (41) includes:

- a quarter wave transformer (412) for keeping the drain load of the power sense circuit (41) approximately constant; and
- a tuned circuit (402) for producing the second reference signal (SREF2) responsive to said to be amplified signal (SIN2) to be used as a feedback signal in an amplifier.

14. A feedback system according to claim 12 or 13 **characterised in that**:

- the second reference signal (SREF2) represents the output signal of the last amplifying stage.

15. A feedback system according to one of claims 12 to 14, **characterised in that**:

said feedback system is a polar loop amplifier which is configured to produce the corrected signal (SIN').

16. A mobile terminal, or a mobile phone, or a base station for a mobile network, comprising a feedback system according to any one of the preceding claims 12 to 15.

**Patentansprüche**

1. Leistungssteuerungsverfahren für einen Verstärker, umfassend die folgenden Schritte:

- Verstärken eines Eingabesignals (SIN) an ein Ausgabesignal (SOUT) durch die Verwendung einer Vielzahl von Verstärkungsstufen;
- Sammeln eines ersten Referenzsignals (SREF1), das das Ausgabesignal (SOUT) darstellt;
- Sammeln eines zweiten Referenzsignals (SREF2),
- Erzeugen eines Rückkopplungssignals (SFBK) unter Verwendung des ersten Referenzsignals (SREF1) und des zweiten Referenzsignals (SREF2) durch die Kombination des ersten Referenzsignals und des zweiten Referenzsignals;
- Verwenden des Rückkopplungssignals (SFBK) zur Steuerung des Verstärkungsschritts, um ein korrigiertes Eingabesignal (SIN') an das Ausgabesignal (SOUT) zu verstärken, und so die Linearität des Verstärkers (105) zu verbessern, wobei das korrigierte Eingabesignal (SIN') durch die Korrektur des Eingabesignals (SIN) mit einem Signal (SFBK$_{am}$, SFBK$_{pm}$) erzeugt wird, das vom Rückkopplungssignal (SFBK) abgeleitet ist;
- wobei das zweite Referenzsignal (SREF2) vom Verstärkungsschritt durch die Verwendung eines Transistors (T2, Y Finger) gesammelt wird, wobei es sich um eine verkleinerte (Y<<X) Version eines Transistors (T1, X Finger) der letzten Verstärkungsstufe handelt, der das Ausgabesignal (SOUT) darstellt;
- wobei der Transistor (T1) in der letzten Verstärkungsstufe und der verkleinerte Transistor (T2) gekoppelt sind, um mit einem Signal (SIN2) ausgestattet zu werden, das verstärkt werden soll, und welches für beide Transistoren (T2, T2) gleich ist.

2. Verfahren nach Anspruch 1, wobei die Steuerung des Verstärkungsschritts die folgenden Schritte umfasst:

- in einem ersten Vergleichsschritt, Vergleichen einer Amplitudendarstellung des Eingabesignals (SIN) mit einer Amplitudendarstellung des Rückkopplungssignals (SFBK);
- in einem zweiten Vergleichsschritt, Vergleichen einer Phasendarstellung des Eingabesignals (SIN) mit einer Phasendarstellung des Korrektursignals (SFBK); und
- Verwenden eines Signals, das vom ersten Vergleichsschritt abgeleitet ist, um einen Leistungsverstärkungsschritt eines Signals zu steuern, der vom zweiten Vergleichsschritt abgeleitet ist, um das Ausgabesignal (SOUT) zu erzeugen.

3. Verfahren nach Anspruch 1 oder 2, wobei: die Steuerung des Verstärkungsschritts den folgenden Schritt umfasst: Verstärken/Dämpfen des Rückkopplungssignals (SFBK) vor einem des ersten und/oder des zweiten Vergleichsschritts.

4. Verfahren nach Anspruch 3, wobei: die Steuerung des Verstärkungsschritts weiter den folgenden Schritt umfasst: das Signal, das vom ersten Verstärkungsschritt abgeleitet ist, wird zuerst gedämpft/verstärkt, bevor es für die Steuerung des Leistungsverstärkungsschritts verwendet wird.

5. Verfahren nach einem der vorhergehenden Ansprüche, wobei: das Rückkopplungssignal (SFBK) durch die Kombination des ersten Referenzsignals (SREF1) mit dem zweiten Referenzsignal (SREF2) erzeugt wird, indem ihnen Gewichte (mod ($C_1$, $C_2$) und/oder Phasen arg($C_1$, $C_2$) zugewiesen werden, die im Kombinationsschritt verwendet werden.

6. Verfahren nach Anspruch 5, wobei die Gewichte (mod ($C_1$, $C_2$)) und/oder Phasen (arg(C1, C2)) je nach dem Leistungsniveau des Ausgabesignals (SOUT) zugewiesen werden.

7. Verfahren nach einem der vorhergehenden Ansprüche, wobei das erste Referenzsignal (SREF1) durch seine Kopplung vom Ausgabesignal (SOUT) nach dem Verstärkungsschritt gesammelt wird.

8. Verfahren nach einem der vorhergehenden Ansprüche, wobei das erste Referenzsignal (SREF1) durch einen Dämpfer oder einen Kondensator vom Ausgabesignal (SOUT) nach dem Verstärkungsschritt gesammelt wird.

9. Verfahren nach einem der vorhergehenden Ansprüche, **dadurch gekennzeichnet, dass**:

es eine Rückkopplungsschleife verwendet, wobei es sich um eine polare Schleife handelt,

10. Verfahren nach einem der vorhergehenden Ansprüche, **dadurch gekennzeichnet, dass**:

es eine Rückkopplungsschleife verwendet, wobei es sich um eine Hüllkurven-Rückkopplungsschleife handelt.

11. Verfahren nach einem der vorhergehenden Ansprüche, **dadurch gekennzeichnet, dass**:

es eine Rückkopplungsschleife verwendet, wobei es sich um eine kartesische Schleife handelt.

12. Rückkopplungssystem, um ein Rückkopplungssignal für einen Leistungsverstärker (105) bereitzustellen, wobei das System eine Vielzahl von Verstärkungsstufen umfasst, um ein Eingabesignal (SIN) an ein Ausgabesignal (SOUT) zu verstärken:

- Mittel (110), um ein erstes Referenzsignal (SREF1) zu erhalten, das das Ausgabesignal darstellt,
- eine Leistungsabfühlschaltung (41) zum Erhalt eines zweiten Referenzsignals (SREF2);
- einen Signalkombinierer (120) zur Erzeugung eines Rückkopplungssignals (SFBK) durch die Kombination des ersten Referenzsignals (SREF1) mit dem zweiten Referenzsignal (SREF2);
- einen Vergleicher (331) und/oder Phasendetektor (341), der ausgelegt ist, um das Eingabesignal (SIN) mit einem Signal ($SFBK_{AM}$, $SFBK_{PM}$), abgeleitet vom Rückkopplungssignal (SFBK), zu korrigieren, um ein korrigiertes Eingabesignal (SIN') zu erzeugen, um das korrigierte Eingabesignal (SIN') an das Ausgabesignal (SOUT) mit dem Verstärker (105) zu verstärken, und somit die Linearität des Verstärkers (105) zu verbessern;
- wobei die Leistungsabfühlschaltung (41) Folgendes umfasst:

einen Transistor (T2, Y Finger), wobei es sich um eine verkleinerte Version (Y<<X) des Transistors (T1, X Finger) des Verstärkers (105) handelt, um ein zweites Referenzsignal (SREF2) zu erhalten, das das Ausgabesignal einer letzten Verstärkungsstufe darstellt; und

- wobei der Transistor (T1) der letzten Verstärkungsstufe und der verkleinerte Transistor (T2) gekoppelt sind, um mit einem Signal (SIN2) ausgestattet zu werden, das verstärkt werden soll, und für beide Transistoren (T2, T2) gleich ist.

13. Rückkopplungssystem nach Anspruch 12,
**dadurch gekennzeichnet, dass**:

eine Leistungsabfühlschaltung (41) Folgendes umfasst:

- einen Viertelwellenumwandler (412), um die Ablauflast der Leistungsabfühlschaltung (41) ungefähr konstant zu halten; und
- eine abgestimmte Schaltung (402), um das zweite Referenzsignals (SREF2) zu erzeugen, das auf das Signal, das verstärkt werden soll (SIN2), reagiert, um als ein Rückkopplungssignal in einem Verstärker verwendet zu werden.

14. Rückkopplungssignal nach Anspruch 12 oder 13, **dadurch gekennzeichnet, dass**:

- das zweite Referenzsignal (SREF2) das Ausgabesignal der letzten Verstärkungsstufe darstellt.

15. Rückkopplungssignal nach einem der Ansprüche 12 bis 14, **dadurch gekennzeichnet, dass**:

das Rückkopplungssystem ein Verstärker mit polarer Schleife ist, der konfiguriert ist, um das korrigierte Signal (SIN') zu erzeugen.

16. Mobiles Endgerät oder Mobiltelefon oder Basisstation für ein mobiles Netzwerk, umfassend ein Rückkopplungssystem nach einem der vorhergehenden Ansprüche 12 bis 15.


**Revendications**

1. Procédé de commande de puissance pour un amplificateur comprenant les étapes :

- d'amplification d'un signal d'entrée (SIN) sur un signal de sortie (SOUT) par utilisation d'une pluralité d'étages d'amplification ;
- de collecte d'un premier signal de référence (SREF1) représentant le signal de sortie (SOUT) ;
- de collecte d'un second signal de référence (SREF2) ;
- de production d'un signal de rétroaction (SFBK) à l'aide du premier signal de référence (SREF1) et du second signal de référence (SREF2) par combinaison du premier signal de référence et du second signal de référence ;
- d'utilisation dudit signal de rétroaction (SFBK) pour commander l'étape d'amplification afin d'amplifier un signal d'entrée corrigé (SIN') sur le signal de sortie (SOUT), améliorant ainsi la linéarité de l'amplificateur (105), le signal d'entrée corrigé (SIN') étant produit par correction du signal d'entrée (SIN) avec un signal (SFBK$_{am}$, SFBK$_{pm}$) dérivé du signal de rétroaction (SFBK) ;
- le second signal de référence (SREF2) étant collecté à partir de l'étape d'amplification par utilisation d'un transistor (T2, Y doigts) qui est une version de taille réduite (Y<<X) d'un transistor (T1, X doigts) du dernier étage d'amplification, représentant le signal de sortie (SOUT) ;
- ce par quoi le transistor (T1) dans le dernier étage d'amplification et le transistor de taille réduite (T2) sont couplés de façon à se voir fournir un signal (SIN2) à amplifier qui est le même pour les deux transistors (T2, T2).

2. Procédé selon la revendication 1, dans lequel : la commande de l'étape d'amplification comprend les étapes :

- dans une première étape de comparaison, de comparaison d'une représentation d'amplitude du signal d'entrée (SIN) avec une représentation d'amplitude du signal de rétroaction (SFBK) ;
- dans une seconde étape de comparaison, de comparaison d'une représentation de phase du signal d'entrée (SIN) avec une représentation de phase du signal de correction (SFBK) ; et
- d'utilisation d'un signal dérivé de la première étape de comparaison pour commander une étape d'amplification de puissance d'un signal dérivé de la seconde étape de comparaison pour produire le signal de sortie (SOUT).

3. Procédé selon la revendication 1 ou 2, dans lequel : la commande de l'étape d'amplification comprend en outre l'étape : d'amplification/atténuation du signal de rétroaction (SFBK) avant l'une quelconque de la première et/ou de la seconde étape de comparaison.

4.  Procédé selon la revendication 3, dans lequel : la commande de l'étape d'amplification comprend en outre l'étape selon laquelle :

    - le signal dérivé de la première étape d'amplification est d'abord atténué/amplifié avant d'être utilisé pour commander l'étape d'amplification de puissance.

5.  Procédé selon l'une quelconque des revendications précédentes, dans lequel : le signal de rétroaction (SFBK) est produit par combinaison du premier signal de référence (SREF1) avec le second signal de référence (SREF2) en leur donnant des pondérations ($mod(C_1, C_2)$) et/ou des phases ($arg(C_1, C_2)$) utilisées dans l'étape de combinaison.

6.  Procédé selon la revendication 5, dans lequel : les pondérations ($mod(C_1, C_2)$) et/ou les phases ($arg(C_1, C_2)$) sont données en fonction du niveau de puissance du signal de sortie (SOUT).

7.  Procédé selon l'une quelconque des revendications précédentes, dans lequel : le premier signal de référence (SREF1) est collecté en le couplant à partir du signal de sortie (SOUT) après l'étape d'amplification.

8.  Procédé selon l'une quelconque des revendications précédentes, dans lequel : le premier signal de référence (SREF1) est collecté par un atténuateur ou un condensateur à partir du signal de sortie (SOUT) après l'étape d'amplification.

9.  Procédé selon l'une quelconque des revendications précédentes, **caractérisé en ce que** :

    il utilise une boucle de rétroaction qui est une boucle polaire.

10. Procédé selon l'une quelconque des revendications précédentes, **caractérisé en ce que** :

    il utilise une boucle de rétroaction qui est une boucle de rétroaction à enveloppe.

11. Procédé selon l'une quelconque des revendications précédentes, **caractérisé en ce que** :

    il utilise une boucle de rétroaction qui est une boucle cartésienne.

12. Système de rétroaction pour donner un signal de rétroaction pour un amplificateur de puissance (105), le système comprenant une pluralité d'étages d'amplification pour amplifier un signal d'entrée (SIN) sur un signal de sortie (SOUT) :

    - un moyen (110) pour obtenir un premier signal de référence (SREF1) représentant le signal de sortie ;
    - un circuit de détection de puissance (41) pour obtenir un second signal de référence (SREF2) ;
    - un coupleur de signaux (120) pour produire un signal de rétroaction (SFBK) par combinaison du premier signal de référence (SREF1) avec le second signal de référence (SREF2) ;
    - un comparateur (331) et/ou un détecteur de phase (341) apte à corriger le signal d'entrée (SIN) avec un signal (SFBK$_{AM}$, SFBK$_{PM}$) dérivé du signal de rétroaction (SFBK) afin de produire un signal d'entrée corrigé (SIN') pour amplifier le signal d'entrée corrigé (SIN') sur le signal de sortie (SOUT) avec l'amplificateur (105), améliorant ainsi la linéarité de l'amplificateur (105) ;
    - ce par quoi le circuit de détection de puissance (41) comprend un transistor (T2, Y doigts) qui est une version de taille réduite (Y<<X) du transistor (T1, X doigts) de l'amplificateur (105) pour obtenir le second signal de référence (SREF2) représentant le signal de sortie d'un dernier étage d'amplification ; et
    - ce par quoi le transistor (T1) du dernier étage d'amplification et le transistor de taille réduite (T2) sont couplés de façon à se voir fournir un signal (SIN2) à amplifier qui est le même pour les deux transistors (T2, T2).

13. Système de rétroaction selon la revendication 12, **caractérisé en ce que** :

    le circuit de détection de puissance (41) comprend :

        - un transformateur quart d'onde (412) pour conserver la charge de drain du circuit de détection de puissance (41) approximativement constante ; et
- un circuit syntonisé (402) pour produire le second signal de référence (SREF2), en réponse audit signal à amplifier (SIN2), devant être utilisé comme un signal de rétroaction dans un amplificateur.

14. Système de rétroaction selon la revendication 12 ou 13, **caractérisé en ce que** :

- le second signal de référence (SREF2) représente le signal de sortie du dernier étage d'amplification.

15. Système de rétroaction selon l'une des revendications 12 à 14, **caractérisé en ce que** :

ledit système de rétroaction est un amplificateur à boucle polaire qui est configuré pour produire le signal corrigé (SIN').

16. Terminal mobile, ou téléphone mobile, ou station de base pour un réseau mobile, comprenant un système de rétroaction selon l'une quelconque des revendications précédentes 12 à 15.

# FIG 1

EP 1 416 628 B1

FIG 2B

FIG 2A

TIME

TIME

Tm

Tc

C

E

FIG 3

FIG 4

VDD

PART OF THE
LAST STAGE OF
POWER
AMPLIFIER 105

42

412

411

402
TUNED
CIRCUIT

41

P₁

SREF2

SIN2

T2

403
TUNED
CIRCUIT

SOUT

Z2

SIN2

T1

Z1

EP 1 416 628 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5570063 A
- EP 0054811 A1
- US 5920808 A
- WO 02060051 A2
- WO 02087072 A2
- US 6320461 B1
- GB 2354384 A
- US 6625943 B1
- EP 0503718 A1
- GB 2370169 A
- US 20020093378 A1
- EP 1217753 A1
- EP 1217754 A1

**Non-patent literature cited in the description**

- **LEONARD R. KAHN.** Single-Sideband Transmission by envelope elimination and restoration. *Proceedings of the I.R.E,* 1952, 803-806
- **V. PETROVIC ; W. GOSLING.** Polar-Loop Transmitter. *Electronics Letters,* 10 May 1979, vol. 15 (10), 286-288